# EUROPEAN PATENT APPLICATION

(11) **EP 1 947 215 A2**
(43) Date of publication of application: **23.07.2008**
(21) Application number: 08250222.0
(22) Date of filing: 17.01.2008
(51) Int. Cl.: C23C 18/16, C23C 18/48

(54) **Method for forming a displacement tin alloy plated film, displacement tin alloy plating bath and method for maintaining a plating performance**

(30) Priority: 22.01.2007 JP 2007011175
(71) Applicant: C. UYEMURA & CO, LTD, Osaka-shi Osaka (JP)
(72) Inventor: Kiso, Masayuki, Hirakata-shi Osaka (JP); Maeda, Tsuyoshi, Hirakata-shi Osaka (JP); Kamitamari, Tohru, Hirakata-shi Osaka (JP)
(74) Representative: Stoner, Gerard Patrick

(57) **Abstract**

Disclosed herein is a method for forming a displacement tin alloy plated film, on a copper or a copper alloy on a substrate, a tin alloy plated film containing at least one additive metal selected from silver, bismuth, palladium, indium, zinc and antimony, the method including the steps of: forming an under layer on the copper or copper alloy in a low temperature displacement tin alloy plating bath at a temperature of 10 to 50° C; and forming an upper layer on the under layer in a high temperature tin alloy plating bath at a temperature of 40 to 80°C to form the displacement tin alloy plated film formed of the under layer and the upper layer.

## Description

### BACKGROUND

The present invention relates to a method for forming a displacement tin alloy plated film suited as a final surface treatment of printed circuit boards and electronic parts, a displacement tin alloy plating bath used in the method and a method for maintaining a plating performance of a plating bath in the above-mentioned method.

Various types of lead-free solders have been proposed as a substitute for tin-lead alloy solders. Where a lead-free solder is applied onto portions to be soldered of different types of substrates, a tin plated film formed on the portion to be soldered as an underlying film is required not only to have direct characteristics to solders such as solderability, solder bondability and the like, but also to inhibit formation of whiskers causing short-circuiting. One of important factors determining these characteristics is uniformity of a tin plated film formed on the substrate at a portion to be soldered.

With a tin-plated film, other metal components are added to tin so as to inhibit whisker formation. In this connection, with the formation of a tin alloy plated film to which second and third metallic components are added to tin is formed on a substrate such as of copper or the like, if a plated film of a given thickness necessary for practical application is formed, the thickness distribution of the film varies and a uniform thickness cannot be obtained, resulting in an adverse influence on solder bondability. Lead-free solders are inferior in solderability to tin-lead alloys. Although this can be improved when a tin alloy plated film serving as an underlying film is melted together with a solder. However, a tin alloy plated film of a non-uniform thickness causes the lowering of solderability.

The references of the above described related art are shown in for example: Japanese Patent Laid-open No. 2006-37227; Japanese Patent No. 3314967; Japanese Patent Laid-open No. 2002-317275; JP-A-2004-534151; Japanese Patent No. 3419995; JP-A-2003-514120; JP-A-2002-513090; U.S. Published Application No. 2002/0064676; U.S. Patent No. 6361823; and U.S. Patent No. 6720499.

Under these circumstances, the present invention has for its object the provision of a method for forming a displacement tin alloy plated film being inhibited a whisker formation in such a way that the tin alloy plated film can be formed as a film having excellent uniformity ensuring good solderability and solder bondability for lead-free solders. The present invention has for another object the provision of a displacement tin alloy plating bath used in the method. The present invention has for another object the provision of a method for maintaining the plating performance of a plating bath in operation thereof.

The inventors made intensive studies so as to attain the above object and, as a result, found that, as a method for forming a tin alloy plated film containing at least one additive metal selected from silver, bismuth, palladium, indium, zinc and antimony is formed on a copper or a copper alloy on a substrate, a novel method for forming a tin alloy plated film by the steps of forming initially an under layer on the copper or copper alloy in a low temperature displacement tin alloy plating bath at a temperature of 10 to 50°C, and forming secondary an upper layer on the under layer in a high temperature substituted tin alloy plating bath at a temperature of 40 to 80°C, which is higher than the low temperature displacement tin alloy plating bath. There is obtained a tin alloy plated film being inhibited a whisker formation with excellent uniformity ensuring good solderability and solder bondability for lead-free solders. The present invention has been accomplished based oh this.

The present invention provides a method for forming a displacement tin alloy plated film, a displacement tin alloy plating bath and a method for maintaining a plating performance indicated below.
[1] A method for forming a displacement tin alloy plated film consisting of an under-layer and an upper layer on a copper or a copper alloy of a substrate, wherein the displacement tin alloy plated film contains at least one additive metal selected from silver, bismuth, palladium, indium, zinc and antimony, and the method comprises the steps of:
   forming the under layer on the copper or copper alloy in a low temperature displacement tin alloy plating bath at a temperature of 10 to 50°C; and
   forming the upper layer on the under layer in a high temperature tin alloy plating bath at a temperature of 40 to 80° C.
[2] The method for forming the displacement tin alloy plated film of [1], wherein said displacement tin alloy plating bath comprises:
   (A) 1 to 50 g/L, based on tin, of a divalent tin compound;
   (B) 0.1 to 5 mol/L of an acid capable of yielding the same anion as the anion generated from the divalent tin compound;
   (C) 50 to 250 g/L of thiourea; and
   (D) 1 to 1000 ppm, based on the additive metal, of a compound of the additive metal.
[3] The method for forming the displacement tin alloy-plated film of [2], wherein a concentration of the component (D) is at 5 to 80 ppm based on the additive metal.
[4] A displacement tin alloy plating bath used in the method of [1], comprising:
   (A) 1 to 50 g/L, based on tin, of a divalent tin compound;
   (B) 0.1 to 5 mol/L of an acid capable of yielding the same anion as the anion generated from the divalent tin compound;
   (C) 50 to 250 g/L of thiourea; and
   (D) 1 to 1000 ppm, based on the additive metal; of a compound of the additive metal.
[5] The displacement tin alloy plated bath of [4], wherein a concentration of the component (D) is at 5 to 80 ppm based on the additive metal.
[6] A method for maintaining a plating performance of the displacement tin plating bath used for plating in the method of [2], wherein the maintenance method comprises continuously or intermittently adding thiourea of the component (C) to said plating bath, in correspondence to an increasing concentration of copper in the plating bath dissolved out by the displacement, in such a way that the thiourea is made at a concentration higher than a concentration of the initial plating bath.
[7] The method for maintaining a plating performance of [6], wherein the maintenance method further comprises continuously or intermittently adding a compound of the additive metal of the component (D) to said plating bath with the thiourea of the component (C) in such a way that the compound of the additive metal is made at a concentration higher than a concentration of the initial plating bath.

We find that by use of the methods disclosed herein, there can be formed a tin alloy plated film with little tendency to whisker formation and which has good uniformity so that it has good solderability and solder bondability when applied with a lead-free solder

### FURTHER EXPLANATIONS; OPTIONS AND PREFERENCES

The present invention is now described in more detail.

In the the present invention, a tin alloy plated film containing at least one additive metal selected from silver, bismuth, palladium, indium, zinc and antimony is formed on a copper or a copper alloy on a substrate.

For the formation, a tin alloy plated under layer is formed by displacement tin strike plating on a copper or a copper alloy in a low temperature displacement tin alloy plating bath at a temperature of 10 to 50°C, preferably 20 to 40°C. Next, a tin alloy plated upper layer is formed on the under layer in a high temperature displacement tin alloy plating bath at a temperature higher than the temperature of the low temperature replacement tin alloy plating bath, i.e. at a temperature of 40 to 80°C, preferably 60 to 80°C.

With the strike plating at low temperatures, a plated film gently deposits, so that a thin dense under layer is formed. Thereafter, an upper layer is formed by increasing a plating rate by high temperature plating, so that a tin alloy plated film having a thickness necessary for practical application can be formed in a uniform thickness on the base of the dense tin alloy under layer. If the strike plating (low temperature plating) is not effected, the deposition reaction proceeds irregularly and thus, a tin alloy-plated film having a uniform thickness distribution cannot be formed and a satisfactory coverage cannot be obtained.

In the present methods, it is possible to form the upper layer by direct immersion in the high temperature displacement tin alloy plating bath after the formation of the under layer without performing other treatments.

In this way, the upper layer can be formed as having a similar or the same plating bath composition as the under layer, so that there is no concern that impurities are entrained when the plating bath is changed for from the under layer to the upper layer. In addition, because treatments such as water washing, acid rinsing and the like need not be (and preferably are not) carried out between the under layer strike plating step and the upper layer plating step, the under layer can be prevented from surface oxidation.

The tin alloy plating bath used preferably contains any one or more or all of (A) divalent tin compound, (B) acid that yields the same anion as anion formed from the divalent tin compound, (C) thiourea and (D) compound of the additive metal (i.e. at least one selected from silver, bismuth, palladium, indium, zinc and antimony).

The divalent tin compounds useful as the component (A) include water-soluble tin salts (stannous salts) such as, for example, stannous sulfate, stannous chloride, stannous methanesulfonic acid and the like. The concentration of the component (A) is preferably 1 to 50 g/L, more preferably 10 to 30 g/L based on tin.

The acid capable of yielding the same anion as the anion formed from the divalent tin compound of the component (B) includes, for example, an acid yielding an anion constituting the above-indicated water-soluble salt. More particularly, when stannous sulfate is used as the component (A), sulfuric acid is used, where stannous chloride is used, hydrochloric acid is used and where stannous methanesulfonate is used, methanesulfonic acid is used. The concentration of the component (B) is preferably 0.1 to 5 mol/L, more preferably 0.5 to 2 mol/L.

The concentration of thiourea used as the component (C) is preferably 50 to 250 g/L, more preferably 100 to 200 g/L.

In the present invention, at least one additive metal selected from silver, bismuth, palladium; indium, zinc and antimony is contained in the tin alloy plated film as a metal other than tin. In the displacement tin alloy plating bath, there is contained a compound of silver, bismuth, palladium, indium, zinc or antimony. The above additive metal is eutectoid in the film, so that the formation of whisker is inhibited. Moreover, it also becomes possible to suppress tin from being diffused into the copper or copper alloy of a substrate.

For an additive metal compound, mention is made of water-soluble salts of the respective additive metals such as methanesulfonates, nitrates, sulfates, carbonates, carboxylates, halides and the like, and oxides of the respective additive metals.

Although the metal species is properly selected depending on the necessity, silver is preferred. With silver, film-forming crystals become fine and if the crystal become fine, the resulting film becomes dense so as to suppress the diffusion of copper or a copper alloy of a substrate, thus silver being favorable. For a lead-free solder which is to be bonded to the tin alloy plated film being formed as an underlying film, tin-silver-copper alloy solders are mainly used, and a tin-silver alloy plated film is preferred from the standpoint that the compositions are close to each other.

The concentration of the component (D) is preferably 1 to 1,000 ppm, more preferably 5 to 80 ppm, still more preferably 10 to 60 ppm and most preferably 15 to 45 ppm, based on the total of additive metals.

Especially, with a displacement tin-silver alloy plating bath, silver is more liable to be deposited than tin, under which if a silver concentration in the solution becomes too high, the copper surface is initially covered with silver, making it difficult to permit tin to be deposited. For example, in Japanese Patent No. 3419995, a non-cyanide complexing agent having a great stability is added so as to suppress such preferential deposition of silver. In the present displacement tin alloy plating bath, the preferential deposition of silver is desirably reduced by setting a silver concentration in the plating bath at a level not higher than 80 ppm beforehand, thereby enabling silver concentration in the tin-silver alloy plated film to be suppressed to a low level. Thus there can be stably formed a tin-silver alloy plated film wherein a rate of silver in the plated film being formed (eutectoid amount) is not higher than 10 wt%, preferably not higher than 5 wt%, without needing a special type of complexing agent. It will be noted that the silver concentration in the tin-silver alloy plated film should preferably be not smaller than 0.1 wt% in order to show a whisker inhibiting effect.

The displacement tin alloy plating bath of the present invention may have admixed one or two or more complexing agents such as organic carboxylic acids including tartaric acid, citric acid, succinic acid, malic acid and the like and salts thereof (e.g. a sodium salt, a potassium salt and an ammonium salt) at a concentration, for example, of 1 to 500 g/L. In addition, the displacement tin alloy plating bath of the present invention may also have admixed a reducing agent such as hypophosphorous acid and a salt thereof (e.g. a sodium salt, a potassium salt or an ammonium salt), for example, at a concentration of 1 to 250 g/L for the purpose of controlling the divalent tin ion in the plating bath for conversion into a quadrivalent tin ion.

Aside from the above components, a surface active agent may be added to the displacement tin alloy plating bath of the present invention in an amount not impeding the effect of the present invention so as to finely grain the deposited crystals of a tin alloy film and obtain a uniform plated film. The surface active agents used include one or two or more of nonionic, cationic, anionic and ampholytic surface active agents. The surface active agents includes polyoxyalkylene alkyl ether surface active agents, polyoxyalkylene alkylamide ether surface active agents, polyoxyalkylene alkylamine ether surface active agents, polyoxyethylenepropylene block polymer surface active agents, alkylamines, alkyltrimethylamines, alkyldimethylamine salts and the like.

In the present invention, the thickness of the tin alloy plated film to be formed is generally at 0.5 to 2.0 µm, preferably 0.9 to 1.3 *µ*m. The thickness of the under layer formed by the low temperature strike plating is typically 0.2 µm or below, preferably 0.01 to 0.1 µm. In this case, the plating time (immersion time) sufficient to provide the above thickness is appropriately selected, and the plating time for the under layer is generally within two minutes, preferably from ten seconds to one minutes, and the plating time for the upper layer ranges about 5 to 50 minutes.

When the displacement tin alloy plating bath used in the present invention uses for plating, copper is dissolved out by the displacement thereby gradually increasing a concentration of copper in the plating bath. In the displacement tin alloy plating bath of the present invention, when the concentration of copper becomes high, the plating rate gradually lowers. In order to stably continue the plating, it is preferred for the supplement of plating bath components to continuously or intermittently add thiourea to the bath, corresponding to the increasing concentration of copper in the plating bath dissolved out by the displacement in such a way that a concentration thereof becomes higher by a given level than the concentration at the time of the initial make-up of the bath (i.e. the concentration of thiourea to be supplied becomes gradually increased). This enables the performance (plating rate) of the plating bath to be well maintained even if the plating bath is repeatedly employed. For example, the variation of the plating rate can be kept within a variation range of ±10% relative to the plating rate immediately after the make-up of the bath.

In this case, it is preferred that the concentration of thiourea is increased, for example, at a rate of 2 to 15% per increment of 1g/L of the copper concentration in the plating bath relative to the concentration at the time of the initial make-up of the bath. For instance, at a stage where the copper concentration is changed from a copper concentration at the time of initial make-up (i.e. 0 g/L) to a copper concentration of 1 g/L, the concentration of thiourea can be made to be at 102 to 115% relative to the concentration of thiourea at initial make-up (i.e. 100%). When at a stage where copper concentration of 2 g/L, the concentration of thiourea can be made to be at 104 to 130% based on the concentration at the initial make-up (i.e. 100%). Moreover, with the case of the copper concentration other than those mentioned above, the concentration may be increased at the same ratio. It will be noted that the plating bath is favorably used at a copper concentration of not greater than 10 g/L in usual practice.

In the displacement tin alloy plating bath used in the present invention, where the thiourea of the component (C) is increased in concentration correspondingly to an increasing concentration of copper in the plating bath as stated above, there is a tendency that a ratio of the additive metal in the deposited tin alloy plated film (i.e. a eutectoid amount) gradually lowers. Accordingly, it is preferred that in order to stably keep a ratio of the additive metal in the tin alloy plated film during the repetition of the plating cycle, supplement of plating bath components is made such that a compound of the additive metal of the component (D) is continuously or intermittently added along with thiourea of the component (C) at a concentration higher by a given level than the concentration at the initial make-up of the bath (i.e. so as to gradually increase the concentration of the compound of the additive metal of the component (D)). This enables a ratio (eutectoid amount) of the additive metal in the formed plated film to be stably maintained if the plating bath is repeatedly used. For instance, the ratio (eutectoid amount) of the additive metal can be maintained within a range of ±1 wt% based on the ratio (eutectoid amount) of the additive metal immediately after the initial make-up of the bath.

In this case, it is preferred-that the concentration of a compound of an additive metal is increased, for example, at a rate of 0 to 20%, preferably 0.1 to 10% and more preferably 1 to 5% per increment of 1g/L of the copper concentration in the plating bath relative to the concentration at the time of the initial make-up of the bath. For instance, at a stage where the copper concentration is changed from a copper concentration at the time of initial make-up (i.e. 0 g/L) to a copper concentration of 1 g/L, the concentration of the compound of the additive metal can be made to be at 100 to 120%, preferably 100.1 to 110% and more preferably 101 to 105%, and at a stage where the copper concentration is at 2 g/L, the concentration of the additive metal compound can be made to be at 100 to 140%, preferably 100.2 to 120% and more preferably 102 to 110%, both based on the concentration at the initial make-up (i.e. 100%). Moreover, with the case of the copper concentration other than those mentioned above, the concentration can be increased at the same ratio.

It will be noted that with respect to the supplement of components other than the thiourea of the component (C) and a compound of an additive metal of the component (D), the concentrations at the time of the initial make-up, respectively, can be maintained by controlling at given concentrations, thereby keeping the performance of the bath.

The present invention is suited as a surface treatment for lead-free printed circuit boards, which is a substitute for HASL (hot air solder leveling) and also as an SOP (solder on pad) underlying treatment for a PKG (package) substrate. Displacement tin alloy plating can be performed on a copper or copper alloy substrate ordinarily employed as a wiring material.

### EXAMPLES

Examples and Comparative Examples are shown to more particularly illustrate the present invention, which should not be construed as limited to the following Examples.

### Examples 1 to 3, Comparative Example 1

A displacement tin alloy plating bath having the following bath composition 1 was provided and used both for a low temperature bath and a high temperature bath. As a test piece, there was used a rolled copper sheet on which a copper film having a thickness of about 10 µm had been formed by copper sulfate electroplating. The test piece was subjected to degreasing and acid cleaning, followed by immersion in a low temperature displacement tin alloy plating bath and subsequent immersion in a high temperature displacement tin alloy plating bath for Examples 1 to 3. In Comparative Example 1, only treatment with the high temperature displacement tin alloy plating bath was performed without use of the low temperature displacement tin alloy plating bath. The temperature and immersion time of the respective baths are indicated in Table 1. It will be noted that the results of a deposition rate upon plating, a coverage (thickness distribution) of the resulting tin alloy plated films and evaluation on the presence or absence of occurrence of whisker are shown in Table 2.

| <Bath composition 1> | |
|---|---|
| Tin methanesulfonate (as Sn²⁺): | 25 g/L |
| Methanesulfonic acid: | 100 g/L |
| Sodium tartrate: | 100 g/L |
| Sodium hypophosphate: | 100 g/L |
| Thiourea: | 150 g/L |
| Silver nitrate (as Ag⁺): | 50 mg/L |
| Polyoxyethylene nonylphenyl ether: | 1 g/L |

**Table 1**

| | Low temperature displacement tin alloy plating bath | | High temperature displacement tin alloy plating bath | |
|---|---|---|---|---|
| | Bath temperature | Immersion time | Bath temperature | Immersion time |
| Example 1 | 10° C | 1 min | 40° C | 10 min |
| Example 2 | 30° C | 1 min | 70° C | 10 min |
| Example 3 | 50° C | 1 min | 80° C | 10 min |
| Comparative Example 1 | - | - | 70°C | 10 min |

### Example 4, Comparative Example 2

A displacement tin alloy plating bath having the following bath composition 2 was provided and used both for a low temperature bath and a high temperature bath. As a test piece, there was used a rolled copper sheet on which a copper film having a thickness of about 10 µm had been formed by copper sulfate electroplating. The test piece was subjected to degreasing and acid cleaning, followed by immersion (one minute) in a low temperature displacement tin alloy plating bath (30°C) and subsequent immersion (10 minutes) in a high temperature displacement tin alloy plating bath (70°C) for Example 4. In Comparative Example 2, the test piece was initially immersed (10 minutes) in a high temperature displacement tin alloy plating bath (70°C) and subsequently immersed (one minute) in a low temperature displacement tin alloy plating bath (30°C). It will be noted that the results of a deposition rate upon plating, a coverage (thickness distribution) of the resulting tin alloy plated film and evaluation on the presence or absence of occurrence of whisker are shown in Table 2.

| <Bath composition 2> | |
|---|---|
| Stannous sulfate (as Sn²⁺): | 25 g/L |
| Sulfuric acid: | 100 g/L |
| Hypophosphorous acid: | 50 g/L |
| Citric acid: | 100 g/L |
| Thiourea: | 100 g/L |
| Indium sulfate (as In⁺): | 100 mg/L |
| Laurylamine hydrochloride: | 1 g/L |

### Examples 5, 6 and Comparative Examples 3, 4

A displacement tin alloy plating bath having the following bath composition 3 was provided and used both for a low temperature bath and a high temperature bath. It will be noted that the baths of the respective examples contained silver as Ag⁺ in amounts of 40 mg/L (Example 5), 80 mg/L (Example 6), 1 mg/L (Comparative Example 3), and 500 mg/L (Comparative Example 4). As a test piece, there was used a rolled copper sheet on which a copper film having a thickness of about 10 µm had been formed by copper sulfate electroplating. The test piece was subjected to degreasing and acid cleaning, followed by immersion (one minute) in a low temperature displacement tin alloy plating bath (30°C) and subsequent immersion (10 minutes) in a high temperature displacement tin alloy plating bath (70°C). It will be noted that the results of a deposition rate upon plating, a coverage (thickness distribution) of the resulting tin alloy plated film and evaluation on the presence or absence of occurrence of whisker are shown in Table 2.

| <Bath composition 3> | |
|---|---|
| Stannous chloride (as Sn²⁺): | 25 g/L |
| Hydrochloric acid: | 50 g/L |
| Sodium hypophosphate: | 50 g/L |
| Succinic acid: | 100 g/L |
| Thiourea: | 150 g/L |
| Silver nitrate (as Ag⁺): | 40 mg/L (Example 5), |
| | 80 mg/L (Example 6), |
| | 1 mg/L (Comparative Example 3), |
| | 500 mg/L (Comparative Example 4) |
| Stearylamine hydrochloride: | 2 g/L |
| Polyoxyethylene laurylamide ether: | 1 g/L |

**Table 2**

| | | Deposition rate | Coverage (thickness distribution) | Whisker |
|---|---|---|---|---|
| Example | 1 | Δ | ○ | ○ |
| | 2 | ○ | ○ | ○ |
| | 3 | ○ | ○ | ○ |
| | 4 | ○ | ○ | ○ |
| | 5 | ○ | ○ | ○ |
| | 6 | ○ | ○ | ○ |
| Comparative Example | 1 | ○ | × | ○ |
| | 2 | ○ | × | ○ |
| | 3 | ○ | ○ | × |
| | 4 | × | ○ | ○ |

| | | | | |
|---|---|---|---|---|
| Deposition rate ○ : good, Δ : slow but possible in plenty of time, ×: reaction stopped in the midway Thickness distribution ○ : good, ×: thin portions locally existing Whisker ○ : not occurring, ×: occurring (left for six months under the condition of 30°C and 60% RH) | | | | |

### Experimental Examples 1 to 3

A displacement tin alloy plating bath having the following bath composition 4 was provided and used both for a low temperature bath and a high temperature bath. As a test piece, there was used a rolled copper sheet on which a copper film having a thickness of about 10 µm had been formed by copper sulfate electroplating. The test piece was subjected to degreasing and acid cleaning, followed by immersion (one minute) in a low temperature displacement tin alloy plating bath (30°C) and subsequent immersion (15 minutes) in a high temperature displacement tin alloy plating bath (60°C).

This plating operation was repeated, under which thiourea and silver methansulfonate were, respectively, added to make such concentrations as indicated in Tables 3 to 5 in every increment of 1 g/L of a copper concentration in the low temperature displacement tin alloy plating bath and the high temperature displacement tin alloy bath. In Experimental Example 1, the concentrations of thiourea and silver methanesulfonate were not increased as indicated in Table 3. In Experimental Example 2, the concentration of thiourea was increased and the concentration of silver methanesulfonate was not increased as indicated Table 4. In Experimental Example 3, the concentrations of both thiourea and silver methanesulfonate were increased as indicated in Table 5. It will be noted that tin consumed by repetition of the plating was appropriately supplemented and its make-up concentration was maintained. The make-up concentrations of other components were maintained by supplementing amounts corresponding to their reductions in amount by dragging-out, respectively.

The plating rates in the displacement tin alloy plating and silver concentrations (eutectoid amount) in the resulting tin alloy plated film immediately after the initial make-up of the bath and immediately after addition of plating components are both shown in Tables 3 to 5.

| <Bath composition 4> | |
|---|---|
| Tin methanesulfonate (as Sn²⁺): | 20 g/L |
| Methanesulfonic acid: | 100 g/L |
| Ammonium hypophosphate: | 100 g/L |
| Malic acid: | 100 g/L |
| Succinic acid: | 50 g/L |
| Thiourea: | 130 g/L |
| Silver methanesulfonate (as Ag⁺): | 30 mg/L |

**Table 3**

| Copper (g/L) | 0 initial make-up of bath | 1 | 2 | 3 | 4 | 5 | 6 | 7 | 8 | 9 | 10 |
|---|---|---|---|---|---|---|---|---|---|---|---|
| Thiourea (g/L) | 130 | 130 | 130 | 130 | 130 | 130 | 130 | 130 | 130 | 130 | 130 |
| Silver (ppm) | 30 | 30 | 30 | 30 | 30 | 30 | 30 | 30 | 30 | 30 | 30 |
| Plating rate (µm/15 min) | 1.12 | 1.08 | 1.06 | 1.06 | 1.01 | 0.99 | 0.96 | 0.92 | 0.80 | 0.68 | 0.51 |
| Eutectoid amount of Ag (wt%) | 1.9 | 1.9 | 2.0 | 2.3 | 2.1 | 2.2 | 1.9 | 2.1 | 1.8 | 2.0 | 1.9 |

**Table 4**

| Copper (g/L) | 0 initial make-up of bath | 1 | 2 | 3 | 4 | 5 | 6 | 7 | 8 | 9 | 10 |
|---|---|---|---|---|---|---|---|---|---|---|---|
| Thiourea (g/L) | 130 | 135 | 140 | 145 | 150 | 155 | 160 | 165 | 170 | 175 | 180 |
| Silver (ppm) | 30 | 30 | 30 | 30 | 30 | 30 | 30 | 30 | 30 | 30 | 30 |
| Plating rate (µm/15 min) | 1.11 | 1.07 | 1.06 | 1.02 | 1.01 | 0.98 | 0.94 | 1.12 | 1.10 | 1.08 | 1.13 |
| Eutectoid amount of Ag (wt%) | 2.1 | 1.9 | 2.1 | 1.9 | 2.0 | 1.7 | 1.8 | 1.7 | 1.6 | 1.5 | 1.3 |

**Table 5**

| Copper (g/L) | 0 initial make-up of bath | 1 | 2 | 3 | 4 | 5 | 6 | 7 | 8 | 9 | 10 |
|---|---|---|---|---|---|---|---|---|---|---|---|
| Thiourea (g/L) | 130 | 135 | 140 | 145 | 150 | 155 | 160 | 165 | 170 | 175 | 180 |
| Silver (ppm) | 30 | 31 | 32 | 33 | 34 | 35 | 36 | 37 | 38 | 39 | 40 |
| Plating rate (µm/15 min ) | 1.11 | 1.09 | 1.06 | 1.07 | 1.09 | 1.06 | 1.12 | 1.11 | 1.08 | 1.09 | 1.08 |
| Eutectoid amount of Ag (wt%) | 2.1 | 1.9 | 1.8 | 1.9 | 1.7 | 2.2 | 2.1 | 1.9 | 2.2 | 2.1 | 1.9 |

From the above results, it will be seen that when the displacement tin alloy plating bath of the present invention is repeatedly used, the addition of thiourea of the component (C) at a concentration higher by a given level than a concentration used at the time of the initial make-up of the bath in correspondence to an increasing concentration of copper in the plating bath dissolved out by the displacement enables the plating performance,(plating rate) of the plating bath to be well maintained. In addition, when a compound of an additive metal of the component (D) is also added along with thiourea of the component (C) at a concentration higher by a given level than a concentration used at the time of the initial make-up of the bath, a rate (eutectoid amount) of the additive metal in the resulting plated film under repeated use conditions of the bath can be stably maintained.

In respect of numerical ranges disclosed herein it will of course be understood that in the normal way the technical criterion for the upper limit is different from the technical criterion for the lower limit, i.e. the upper and lower limits are intrinsically distinct proposals.

## Claims

1. A method of forming a displacement tin alloy plated film consisting of an underlayer and an upper layer on a copper or copper alloy substrate, wherein the displacement tin alloy plated film contains at least one additive metal selected from silver, bismuth, palladium, indium, zinc and antimony, and the method comprises the steps of:
forming the underlayer on the copper or copper alloy in a low temperature displacement tin alloy plating bath at a temperature of from 10 to 50°C, and
forming the upper layer on the underlayer in a high temperature tin alloy plating bath at a higher temperature, of from 40 to 80°C.

2. A method of claim 1 wherein said displacement tin alloy plating bath comprises:
(A) 1 to 50 g/L, based on tin, of divalent tin compound;
(B) 0.1 to 5 mol/L of acid capable of yielding the same anion as the anion generated from the divalent tin compound;
(C) 50 to 250 g/L of thiourea;
(D) 1 to 1000 ppm, based on the additive metal, of a compound of the additive metal.

3. A method of claim 1 or 2, wherein a concentration of the additive metal in the plating bath is from 5 to 80 ppm.

4. A method of claim 1, 2 or 3 in which the underlayer is formed at from 20 to 40°C and the upper layer at from 60 to 80°C.

5. A method of any one of claims 1 to 4 in which the underlayer is formed to 0.2 *µ*m thickness or less.

6. A method of any one of the preceding claims in which the same bath is used for the low temperature and high temperature plating.

7. A displacement tin alloy plating bath useful in, or used in, a method of any one of claims 1 to 6 and comprising:
(A) 1 to 50 g/L, based on tin, of a divalent tin compound;
(B) 0.1 to 5 mol/L of acid capable of yielding the same anion as the anion generated from the divalent tin compound;
(C) 50 to 250 g/L of thiourea;
(D) 1 to 1000 ppm, based on the additive metal, of a compound of the additive metal.

8. A displacement tin alloy plating bath of claim 7, wherein a concentration of the component (D) is at 5 to 80 ppm based on the additive metal.

9. A method of maintaining a plating performance of a displacement tin plating bath used in a method of any one of claims 1 to 6, wherein the maintenance method comprises continuously or intermittently adding thiourea to said plating bath, in correspondence to an increasing concentration of copper in the plating bath dissolved out by the displacement, in such a way that the thiourea concentration is higher than in the initial plating bath.

10. A method of claim 9, wherein the maintenance method comprises continuously or intermittently adding a compound of the additive metal to said plating bath, as well as said thiourea, in such a way that the additive metal concentration is higher than in the initial plating bath.

11. A method of any one of claims 1 to 6, 9 and 10 used as a preliminary to soldering with lead-free solder.
